# DEMANDE DE BREVET EUROPEEN

(11) **EP 4 390 560 A1**
(43) Date de publication de la demande: **26.06.2024**
(21) Numéro de dépôt: 22215943.6
(22) Date de dépôt: 22.12.2022
(51) Int. Cl.: G04B 19/30, G04G 17/02

(54) **CADRAN DE MONTRE COMPRENANT UN DISPOSITIF D'ÉCLAIRAGE**

(71) Demandeur: ETA SA Manufacture Horlogère Suisse, 2540 Grenchen (CH)
(72) Inventeur: HUOT-MARCHAND, Sylvain, 2743 Eschert (CH); DUBUGNON, Dominique, 1162 Saint-Prex (CH)
(74) Mandataire: ICB SA

(57) **Abrégé**

Un aspect de l'invention concerne un cadran (2a, 2b) de montre (1) comprenant un dispositif d'éclairage autonome (3) comportant les éléments fonctionnels suivants :
- au moins une source lumineuse (4),
- une unité d'alimentation électrique autonome (21), et
- une unité de contrôle (7) pour gérer le fonctionnement de la dite au moins une source lumineuse (4),
ledit cadran (2a, 2b) étant formé par un assemblage (9a, 9b) d'une pluralité de couches superposées (10, 11, 12, 13, 14) reliées entre elles et comportant chacune un ou plusieurs éléments fonctionnels du dispositif d'éclairage autonome (3).

## Description

### Domaine technique de l'invention

La présente invention concerne un cadran de montre dotée d'un dispositif d'éclairage totalement autonome.

### Arrière-plan technologique

Dans l'art antérieur, différents types de dispositifs d'éclairage ont été proposés pour les montres afin de permettre la lecture de l'heure dans des conditions de faible luminosité. Ces dispositifs reposent essentiellement sur la présence sur des cadrans de ces montres, de matériaux phosphorescents. De tels matériaux ont été employés avec plus ou moins de succès car tous souffrent de l'inconvénient bien connu d'avoir une efficacité qui diminue dans le temps. De plus, ces matériaux nécessitent généralement une recharge périodique par exposition à la lumière afin que le niveau d'émissions phosphorescentes soit maintenu.

Dans ce contexte, on comprend qu'il existe un besoin de trouver une solution, qui ne présente pas les inconvénients de l'art antérieur.

### Résumé de l'invention

L'invention a pour but de pallier ces inconvénients en proposant une montre dont l'illumination de son cadran présente une efficacité qui reste constante dans le temps.

Un aspect de l'invention concerne un cadran de montre comprenant un dispositif d'éclairage autonome comportant les éléments fonctionnels suivant :
- au moins une source lumineuse,
- une unité d'alimentation électrique autonome, et
- une unité de contrôle pour gérer le fonctionnement de la dite au moins une source lumineuse,
ledit cadran étant formé par un assemblage d'une pluralité de couches superposées reliées entre elles et comportant chacune un ou plusieurs éléments fonctionnels du dispositif d'éclairage autonome.

Un autre aspect de l'invention concerne ...
- l'assemblage est constitué d'une première couche formant une face visible du cadran comprenant au moins une source lumineuse ;
- ladite première couche est configurée pour être traversé en tout ou partie par un rayonnement lumineux notamment par un rayonnement solaire
- ladite première couche est en tout ou partie transparente ou translucide ;
- l'assemblage comporte une deuxième couche comprenant un module photovoltaïque constituant l'unité d'alimentation électrique autonome ;
- la deuxième couche comprend un substrat sur lequel le module photovoltaïque est imprimé ;
- ledit module photovoltaïque est disposé sur une zone active de ladite deuxième couche, ladite zone étant configurée pour recevoir des rayonnements lumineux provenant de la première couche de l'assemblage ;
- l'assemblage comporte une troisième couche comprenant un accumulateur d'énergie électrique constituant l'unité d'alimentation électrique autonome ;
- la troisième couche comprend un substrat sur lequel l'accumulateur d'énergie électrique est imprimé ;
- l'assemblage comporte une quatrième couche formant une face cachée du cadran comprenant l'unité de contrôle ;
- l'assemblage comporte une troisième couche comprenant une face cachée du cadran comportant l'unité de contrôle et un accumulateur d'énergie électrique constituant l'unité d'alimentation électrique autonome ;
- la première couche est rigide relativement aux autres couches comprises dans l'assemblage qui sont souples.

Un autre aspect de l'invention concerne une montre comprenant un tel cadran.

Avantageusement, la montre comprend un mouvement horloger mécanique ou électromécanique ou électronique.

### Brève description des figures

Les buts, avantages et caractéristiques de la montre selon l'invention apparaîtront mieux dans la description suivante sur la base d'au moins une forme d'exécution non limitative illustrée par les dessins sur lesquels :
- la figure 1 représente une vue en perspective d'une montre comprenant un cadran pourvu d'un dispositif d'éclairage autonome, selon des modes de réalisation de l'invention ;
- la figure 2 représente une vue éclatée d'une première variante de l'assemblage de quatre couches superposées formant ledit cadran pourvu du dispositif d'éclairage autonome, lesdites couches comportant chacune un ou plusieurs éléments constitutifs du dispositif d'éclairage, selon un premier mode de réalisation de l'invention ;
- la figure 3 représente une vue schématique de cette première variante de l'assemblage de couches formant le cadran pourvu du dispositif d'éclairage autonome selon le premier mode de réalisation de l'invention ;
- la figure 4 représente une vue éclatée d'une deuxième variante de l'assemblage de trois couches superposées formant ledit cadran pourvu du dispositif d'éclairage autonome, lesdites couches comportant chacune un ou plusieurs éléments constitutifs du dispositif d'éclairage selon un deuxième mode de réalisation de l'invention, et
- la figure 5 représente une vue schématique de cette deuxième variante de l'assemblage de couches formant le cadran pourvu du dispositif d'éclairage autonome selon le deuxième mode de réalisation de l'invention.

### Description détaillée de l'invention

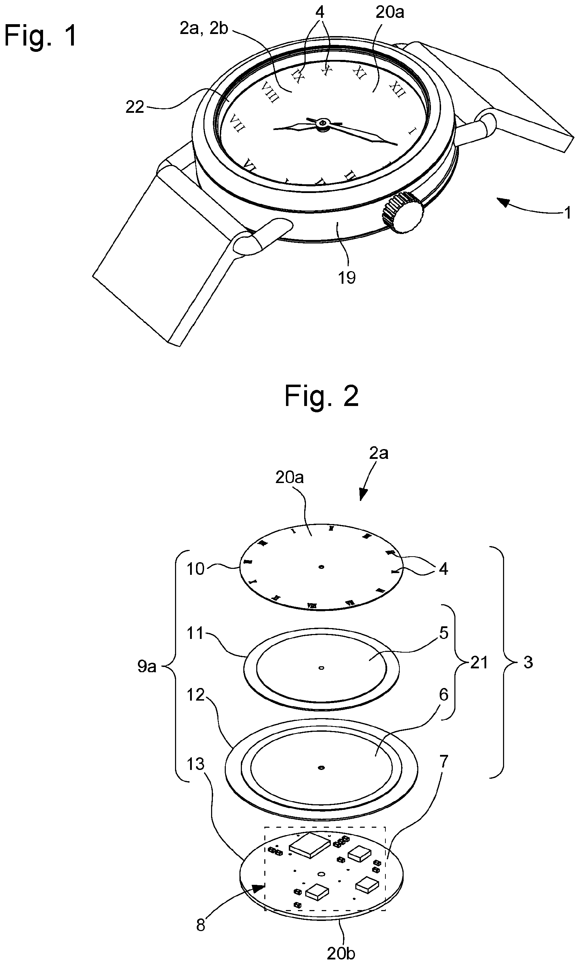

La figure 1 illustre une représentation schématique d'une montre 1 comprenant un boitier 19 pourvu d'une carrure à laquelle sont fixés un fond et une glace 22, d'un ensemble de composants formant un mouvement horloger, et d'un cadran 2a, 2b disposé entre le mouvement horloger et la glace 22.

Le mouvement horloger entraîne de façon connue de l'homme du métier un aiguillage comprenant une aiguille des heures, une aiguille des minutes et éventuellement une aiguille des secondes. A cet effet, le cadran 2a, 2b comporte un trou traversant recevant l'axe des aiguilles. Ce cadran 2a, 2b comprend aussi deux faces 20a, 20b dont :
- une face dite visible 20a de l'extérieur de la montre 1 aussi appelée « *partie visible* » ou « *partie supérieure visible* » de ce cadran 2a, 2b, et
- une face dite cachée 20b agencée en regard du mouvement horloger dans une enceinte du boitier 19 de la montre 1, cette face 20b étant autrement appelée « *partie* cachée » ou « *partie inférieure* cachée » de ce cadran 2a, 2b, 2b.

Une telle face visible 20a comprend au moins une représentation graphique telle que :
- un élément de repère (ou d'affichage) comme par exemple un chiffre, un index, un trait ou encore un point contribuant à participer avec/sans les aiguilles à l'affichage d'une information/grandeur horlogère ou d'une information/grandeur physique mesurée par un capteur ou similaire compris dans le mouvement ;
- une inscription, un motif, un texte, un logo, etc.

On notera par ailleurs que dans les modes de réalisation illustrés sur les figures 1 à 5, le cadran 2a, 2b a de préférence une forme circulaire. On comprend que l'invention peut également être mise en oeuvre pour des cadrans 2a, 2b ayant d'autres formes comme par exemple une forme triangulaire ou encore une forme similaire à celle d'un quadrilatère.

Dans les modes de réalisation de l'invention, le mouvement horloger est un mouvement mécanique. Dans une alternative ce mouvement peut être un mouvement électronique ou encore un mouvement électromécanique. On parlera d'ailleurs par la suite d'une montre mécanique lorsque son mouvement est mécanique et de montres électromécanique et électronique lorsqu'elles comportent respectivement des mouvements électromécanique et électronique.

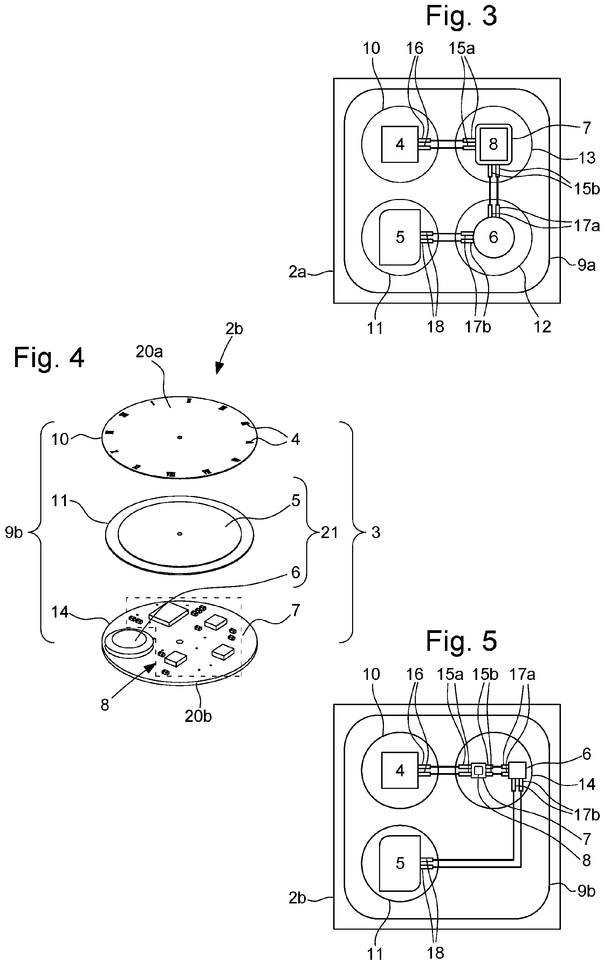

En référence aux figures 2 et 4, un tel cadran 2a, 2b comprend un dispositif d'éclairage autonome 3. Ce dispositif d'éclairage 3 comprend ses propres moyens d'alimentation électrique comme nous le verrons par la suite. Un tel dispositif d'éclairage 3 est dit autonome notamment par rapport au mouvement de la montre 1 et en particulier de la source énergétique de ce mouvement, par exemple lorsque cette source est une alimentation électrique comme dans un mouvement électronique ou un mouvement électromécanique. Dans ces conditions, on comprend que l'énergie utilisée par ce dispositif d'éclairage 3 ne se fait pas au détriment de l'autonomie du mouvement.

Dans ce contexte, le cadran 2a, 2b peut être monté de manière amovible dans la montre 1 quel que soit le type de la montre 1. La seule condition à respecter est que le cadran 2a, 2b comprenne ce dispositif d'éclairage 3 qui est donc autonome par rapport au mouvement de la montre 1.

Ce dispositif d'éclairage 3 compris dans ce cadran 2a, 2b, comporte au moins une source lumineuse 4 aussi appelée source de lumière, une unité d'alimentation électrique autonome 21 et une unité de contrôle 7.

Dans ce contexte, la source lumineuse 4 peut correspondre à n'importe quel élément électroluminescent sélectionné dans une liste comprenant de manière non exhaustive et non limitative :
- un condensateur électroluminescent plus connu sous l'acronyme LEC pour « Light-Emitting Capacitor » ;
- une diode électroluminescente de type LED (acronyme de « Light-Emitting Diode »), OLED (acronyme de « Organic Light-Emitting Diode »), AMOLED (acronyme de « Active-Matrix Organic Light-Emitting Diode ») ou encore QLED (acronyme de « Quantum Light-emitting diode » ;
- tout matériau électroluminescent activé par un champ électrique local ;
- tout matériau électroluminescent activé par un courant électrique ;
- toutes combinaisons de ces éléments électroluminescents.

On notera que cette source lumineuse 4 peut dans certains modes de réalisation de l'invention, être une source lumineuse 4 apte à former une source lumineuse étendue. Ceci permet de donner une forme prédéterminée à la source lumineuse étendue, typiquement, sans que cela ne soit exhaustif ni limitatif, une forme relative à une représentation graphique de chiffre, de lettre, de logo ou encore de texte. On notera en complément, que cette source lumineuse 4 peut produire de la lumière dans n'importe quelle couleur et/ou dans n'importe quelle direction.

Dans ce dispositif d'éclairage 3, l'unité d'alimentation électrique autonome 21 comporte un accumulateur d'énergie électrique 6 et un module photovoltaïque 5 comprenant au moins une cellule photovoltaïque encore appelée cellule solaire. Ce module photovoltaïque 5 est relié à l'accumulateur d'énergie électrique 6 via des éléments de connexions référencés 17b et 18 sur les figures 3 et 5. Ce module photovoltaïque 5 peut comprendre une ou des cellules élémentaires du type à hétérojonction ou multijonction, connectées en parallèle ou en série. Chaque cellule photovoltaïque de ce module 5, peut être réalisée, de manière connue de l'homme du métier, à partir de matériaux semi-conducteur à base de cuivre, d'indium, de gallium et de sélénium, à base de tellurure de cadmium, à base d'arséniure de gallium monocristallin ou à base de silicium monocristallin ou polycristallin, ou à pérovskites. Il y a lieu de noter que ces exemples sont non limitatifs et que l'homme du métier saura trouver le type de cellule photovoltaïque adapté à l'invention.

Dans ce dispositif d'éclairage 3, l'unité de contrôle 7 aussi appelée microcontrôleur, comporte un circuit électronique 8 comprenant des ressources matérielles en particulier au moins un processeur coopérant avec des éléments de mémoire ainsi que des bus d'adresses, de données et de contrôle. Cette unité de contrôle 7 comprend dans ses éléments de mémoire un algorithme de gestion de l'illumination de ladite au moins une source lumineuse 4. Un tel algorithme est exécuté par le processeur de cette unité de contrôle 7 en tenant compte notamment de données provenant de capteurs d'évènement compris dans le dispositif d'éclairage 3 afin d'assurer la gestion du fonctionnement de ladite au moins une source lumineuse 4.

On notera que de telles données peuvent par exemple apporter des informations relatives à des évènements détectés par ces capteurs, lesdits évènements étant susceptibles de contribuer au fonctionnement de ladite au moins une source lumineuse 4. Ces évènements peuvent comprendre de manière non limitative et non exhaustive : la détection d'un niveau de luminosité particulier dans l'environnement de la montre 1, la détection d'un élément sonore particulier ou d'un niveau sonore particulier, la détection d'un objet visuel particulier, la détection d'un mouvement effectué par une partie du corps de l'utilisateur sur laquelle est comprise cette montre 1, etc.

Dans ce contexte, le capteur d'évènement de ce dispositif d'éclairage autonome 3, comprend en particulier et de manière non limitative et non exhaustive :
- un capteur de luminosité permettant de détecter le niveau de luminosité ambiante ;
- un capteur de mouvement d'une partie du corps de l'utilisateur comprenant la montre 1 tel qu'un capteur gyroscopique et/ou inertiel sous la forme d'un composant électronique de type circuit microsystèmes électromécaniques gyroscopique et/ou inertiel ;
- un capteur sonore de type microphone, et/ou
- un capteur optique de type capteur photographique.

Par ailleurs lorsque le dispositif d'éclairage 3 comprend plusieurs sources lumineuses 4, le fonctionnement de ces dernières peut alors être géré/contrôlé par l'unité de contrôle 7 de manière simultanée et/ou en séquence. De plus chaque source lumineuse 4 est gérée/contrôlée par cette unité de contrôle 7 de manière distincte. Dans ce contexte, la gestion du fonctionnement de chaque source lumineuse 4 peut consister de manière non limitative et non exhaustive en la réalisation des opérations suivantes : un allumage ou une extinction séquentiel (le), un allumage ou une extinction simultané (e) de deux ou plusieurs sources lumineuses 4, un clignotement d'une ou de plusieurs sources lumineuses 4, une définition d'une fréquence de clignotement pour chaque source lumineuse 4, une durée de clignotement pour chaque source lumineuse 4, une durée d'allumage ou d'extinction pour chaque source lumineuse 4, etc.

Une telle unité de contrôle 7 peut aussi comprendre dans ses éléments de mémoire un algorithme de gestion de l'accumulateur d'énergie électrique 6 en particulier la gestion de son rechargement par le module photovoltaïque 5 et la gestion de la consommation électrique par ladite source lumineuse 4.

Ainsi que nous l'avons évoqué, le dispositif d'éclairage autonome 3 est donc compris dans le cadran 2a, 2b. Dans cette configuration, les éléments constitutifs de ce dispositif d'éclairage 3 à savoir la source lumineuse 4, l'accumulateur d'énergie électrique 6, le module photovoltaïque 5 et l'unité unité de contrôle 7, sont compris dans une ou plusieurs couches 10, 11, 12, 13, 14 formant ce cadran 2a, 2b.

En référence aux figures 2 à 5, ce cadran 2a, 2b est formé par un assemblage 9a, 9b d'une pluralité de couches 10, 11, 12, 13, 14 de matériau reliées entre elles. Dans cet assemblage 9a, 9b, ces couches 10, 11, 12, 13, 14 sont reliées entre elles par un élément de liaison tel qu'une substance adhésive de manière à les unifier afin obtenir un assemblage 9a, 9b monolithique formant ainsi un cadran monobloc 2a, 2b. Cet élément de liaison peut aussi être un clip ou encore une vis. De telles couches 10, 11, 12, 13, 14 sont superposées dans l'assemblage 9a, 9b c'est-à-dire qu'elles sont agencées les unes au-dessus des autres dans ce cadran 2a, 2b selon un ordre défini.

Ainsi un tel cadran monobloc 2a, 2b, présente en outre l'avantage de pouvoir être monté de manière amovible dans le boitier 19 de la montre 1 en plus de faciliter son intégration dans ce boitier 19.

Dans une première variante de cet assemblage 9a illustré sur la figure 3, ce dernier est constitué de quatre couches 10, 11, 12, 13 successives suivantes :
- une première couche 10 formant/constituant la face visible 20a du cadran 2a incluant ladite au moins une source lumineuse 4 du dispositif d'éclairage 3,
- une deuxième couche 11 incluant le module photovoltaïque 5 ;
- une troisième couche 12 incluant un accumulateur d'énergie électrique 6 aussi appelé batterie rechargeable, et
- une quatrième couche 13 formant la face cachée 20b du cadran 2a incluant l'unité de contrôle 7.

La première couche 10 de cet assemblage 9a, est de préférence rigide ou semi-rigide en comparaison avec les deuxième, troisième et quatrième couches 11, 12, 13 qui sont de préférences souples ou flexibles. On comprend ici qu'une telle première couche 10 participe à rigidifier de manière structurelle l'assemblage 9a et donc le cadran 2a.

Dans cet assemblage 9a, les première, deuxième, troisième et quatrième couches 10, 11, 12, 13, comprennent chacune une surface supérieure et une surface inférieure.

S'agissant de la première couche 10, elle est formée par un substrat transparent ou translucide ou au moins partiellement transparent ou au moins partiellement translucide qui est rigide ou semi-rigide. Un tel substrat est réalisé en une matière présentant une transmittance aux rayonnements solaires en particulier aux rayonnements ultraviolets aussi appelée UVT (pour « Ultra-Violet Transmission ») qui est comprise entre 65 et 95 pourcent. Cette transmittance est de préférence de 85 pourcent. Une telle matière peut être transparente ou translucide. Cette matière peut être de manière non limitative et non exhaustive un polymère, du verre ou encore de la céramique.

Dans ce contexte, on comprend que ce substrat est configuré pour que :
- la lumière produite par ladite au moins une source lumineuse puisse s'échapper vers l'extérieur du cadran 2a, 2b et donc de la montre 1, et
- la lumière provenant de l'environnement de la montre 1 puisse pénétrer dans le cadran 2a, 2b en direction du module photovoltaïque 5 du dispositif d'éclairage 3, cette lumière comprenant des rayonnements solaires lorsqu'elle est d'origine naturelle.

Autrement dit, ce substrat transparent ou translucide est configuré pour être traversé par un rayonnement solaire susceptible d'alimenter le module photovoltaïque 5 afin que ce dernier puisse convertir l'énergie solaire provenant de ce rayonnement en énergie électrique.

Cette première couche 10 comprend aussi au moins une source lumineuse 4 qui est agencée dans le corps du substrat. Un tel agencement de la source lumineuse 4 dans ce substrat est configuré pour assurer un éclairage de tout ou partie de la face visible 20a du cadran 2a. Par exemple, un éclairage d'une représentation graphique telle qu'un élément de repère (ou affichage) comme un chiffre, un index, un trait, un point ou un éclairage d'une ou de plusieurs aiguilles, ou encore un éclairage de tout ou partie de la surface de la face visible du cadran 2a. Dans une variante, cette source lumineuse 4 peut avoir une forme prédéterminée telle que la forme d'un chiffre, d'une lettre, d'un index, d'un trait, d'un point, d'un logo ou encore d'un texte.

Cet éclairage peut être un éclairage de type rétroéclairage ou semi-direct lorsque la source lumineuse 4 est agencée dans une cavité définie dans le substrat. Plus précisément, cette cavité pouvant être une ouverture borgne réalisée dans la surface inférieure de ce substrat. Dans cette configuration, lorsque le fond de cette cavité comprend une représentation graphique, le rayonnement lumineux, ou la lumière, produit par cette source lumineuse 4 peut s'échapper vers l'extérieur du cadran 2a via la face visible 20a de ce cadran 2a, autorisant ainsi la visualisation d'au moins une représentation graphique dans l'obscurité. En particulier, le rayonnement lumineux en s'échappant ainsi de la face visible 20a, vient dessiner le contour de cette représentation graphique. Dans ce contexte, cette représentation graphique comprise dans ou sur la surface supérieure ou encore sur la surface inférieure du substrat formant la première couche 10, est de préférence opaque ou non translucide ou non transparente.

Cet éclairage peut être un éclairage direct lorsque la source lumineuse 4 est agencée dans une cavité définie dans le substrat. Cette cavité peut être une ouverture borgne réalisée dans la surface inférieure de ce substrat et dont le fond est dépourvu de toute représentation graphique. Dans cette configuration, le rayonnement lumineux, ou la lumière, produit par cette source lumineuse 4 peut s'échapper par le fond de cette cavité vers l'extérieur du cadran 2a et donc par la face visible 20a de ce cadran 2a.

Cet éclairage peut aussi être un éclairage direct lorsque la source lumineuse 4 est agencée dans une ouverture traversante s'étendant dans l'épaisseur du substrat de la première couche 10, en débouchant en ses deux extrémités respectivement dans les surfaces supérieure et inférieure de ce substrat. Dans cette configuration, tout ou partie de la source lumineuse 4 peut faire saillie de la surface supérieure de ce substrat et donc de la première couche 10 ou de la face visible 20a du cadran 2a pour former une représentation graphique telle qu'un index, un chiffre, un point, un trait, etc.

Un tel éclairage peut également être un éclairage déporté lorsque ladite au moins une source lumineuse 4 est couplée à au moins un guide d'onde. Ce guide d'onde encore appelé guide de lumière, permet d'amener la lumière depuis le point où elle injectée dans le guide jusque dans le substrat ou jusqu'à une zone du substrat (p. ex. : cavité, ouverture traversante) proche de la surface supérieure de ce substrat. Un tel guide de lumière peut être une fibre optique qui permet de contourner les éventuels obstacles qui peuvent se dresser dans le substrat par exemple entre l'élément électroluminescent et la zone du substrat proche de la surface supérieure de ce substrat, par laquelle la lumière va s'échapper. Dans cette variante de réalisation, c'est donc la lumière qui est amenée, via le guide d'onde, depuis l'élément électroluminescent jusqu'à cette zone du substrat à éclairer.

Dans une telle configuration, une première extrémité du guide d'onde est couplée avec la source lumineuse 4 et une deuxième extrémité de ce guide peut être agencée dans :
- une cavité pouvant être une ouverture borgne réalisée dans la surface inférieure du substrat de cette première couche 10, ou
- une ouverture traversante s'étendant dans l'épaisseur du substrat de la première couche 10 en débouchant en ses deux extrémités respectivement dans les surfaces supérieure et inférieure de ce substrat et donc de la première couche 10. Ainsi cette deuxième extrémité peut faire saillie de la surface supérieure du substrat ou de cette première couche 10 ou de la face visible 20a du cadran 2a afin par exemple de former une représentation graphique de ce cadran 2a comme par exemple un élément de repère tel qu'un index, un chiffre, un point, un trait, etc.

Dans ce contexte, l'éclairage indirect peut être réalisé par une seule source lumineuse 4 comprise sur la surface inférieure du substrat de cette première couche 10 en étant couplée à plusieurs guides d'onde dont les deuxièmes extrémités sont agencées dans :
- des cavités émettant chacune un rayonnement lumineux, provenant de cette source lumineuse 4, ce rayonnement s'échappant vers l'extérieur du cadran 2a via la face visible 20a en autorisant ainsi la visualisation d'au moins une représentation graphique dans l'obscurité. Dans ce contexte, cette représentation graphique comprise dans ou sur la face visible 20a du cadran 2a, ou la surface supérieure du substrat, est de préférence opaque, et/ou
- des ouvertures traversantes en faisant saillie ou pas de la surface supérieure de ce substrat afin de former des éléments de repères tels qu'un index, trait ou encore un point, et émettant chacune un rayonnement lumineux, provenant de cette source lumineuse 4.

Dans cette première couche 10, la source lumineuse 4 est appliquée/fixée sur la surface inférieure du substrat de cette première couche 10, dans une cavité ou sur une paroi interne d'une ouverture traversante évoquée précédemment et ce, par impression ou évaporation.

En outre, on notera que la surface inférieure de cette première couche 10 peut être autocollante afin de participer à son assemblage avec la deuxième couche 11.

Dans cet assemblage 9a, la deuxième couche 11 comprend un substrat comportant le module photovoltaïque 5. Un tel substrat est de préférence flexible ou souple. Ce substrat de la deuxième couche 11, peut être un film sur lequel est disposé le module photovoltaïque 5. Enfin, ce substrat peut être réalisé en un matériau appartenant à la famille des polymères.

Dans cette deuxième couche 11, le module photovoltaïque 5 s'étend préférentiellement sur l'ensemble d'une zone dite active de la surface supérieure de ce substrat. Cette zone active est une portion de la surface supérieure du substrat qui est apte recevoir la lumière provenant de la surface inférieure de la première couche 10 du cadran 2a. Cette lumière qui a traversé tout ou partie de la première couche 10, provient de l'environnement extérieur du cadran 2a, et donc de la montre 1, ici principalement du rayonnement solaire lorsqu'elle est d'origine naturelle.

On notera que le module photovoltaïque 5 est appliqué sur la surface supérieure de ce substrat à partir de procédés d'impression par jet d'encre ou encore par sérigraphie ou à partir de procédés d'impression par évaporation thermique. On parlera d'ailleurs ici d'une deuxième couche 11 comprenant un module photovoltaïque 5 imprimé. En particulier, d'un module photovoltaïque 5 imprimé sur le substrat de la deuxième couche 11.

On remarquera qu'une fois le module photovoltaïque 5 a été appliqué sur le substrat, une couche d'une substance autocollante peut être déposée sur tout ou partie de la surface supérieure et/ou de la surface inférieure du substrat. Dans ces conditions, la deuxième couche 11 peut être une couche autocollante qui participe à faciliter son assemblage avec les autres couches en particulier avec la première couche 10 et/ou la troisième couche 12 de cet assemblage 9a.

Dans l'assemblage 9a, cette troisième couche 12 comprend aussi un substrat de préférence flexible ou souple, comportant l'accumulateur d'énergie électrique 6 du dispositif d'éclairage autonome 3. Ce substrat de la troisième couche 12 peut être un film sur lequel est compris l'accumulateur 6. Un tel substrat peut être réalisé en un matériau appartenant à la famille des polymères.

Cet accumulateur 6 peut être une batterie au lithium ou encore une batterie à semi-conducteurs. Un tel accumulateur 6 est appliqué sur la surface supérieure de ce substrat à partir de procédés connus de l'état de la technique tels que :
- des procédés d'impression sur substrat polymère souple lorsqu'il s'agit par exemple d'une batterie au lithium, ou
- des procédés d'impression tridimensionnelle lorsqu'il s'agit par exemple d'une batterie à semi-conducteurs telle qu'une batterie lithium-métal à semi-conducteurs.

On parlera d'ailleurs ici d'une troisième couche 12 comprenant un accumulateur d'énergie électrique 6 imprimé. En particulier, d'un accumulateur d'énergie électrique 6 imprimé sur le substrat de la troisième couche 12.

Ainsi, de tels procédés permettent d'obtenir une troisième couche 12 comprenant cet accumulateur 6 qui est souple et ultrafine.

En outre, on remarquera qu'une fois l'accumulateur 6 appliqué sur le substrat, une couche d'une substance autocollante peut être déposée sur tout ou partie de la surface supérieure et/ou de la surface inférieure de ce substrat. Dans ces conditions, la troisième couche 12 peut être une couche autocollante qui participe à faciliter son assemblage avec les autres couches en particulier avec la deuxième couche 11 et/ou la quatrième couche 13 de cet assemblage 9a.

On notera que cet accumulateur 6 sert à stocker l'énergie électrique produite par le module photovoltaïque 5 et à la restituer sur demande pour alimenter ladite au moins une source lumineuse 4.

Dans cet assemblage 9a, cette quatrième et dernière couche 13 forme la face cachée du cadran 2a. Une telle quatrième couche 13 est formée par un substrat de préférence flexible ou souple, comportant l'unité de contrôle 7. Un tel substrat de la quatrième couche 13, peut être par exemple un PCB flexible sur lequel est agencée cette unité de contrôle 7 en particulier sur la surface supérieure de ce PCB et donc du substrat. Dans ce contexte, l'édification de l'unité de contrôle 7 sur cette surface supérieure du substrat peut être réalisée à partir de procédés d'impression tridimensionnelle ou encore des procédés d'impression sur polymère.

Dans la deuxième variante, l'assemblage 9b formant le cadran 2b, comprend trois couches 10, 11, 14, reliées entre elles. On remarquera que cette deuxième variante se différencie de la première variante en ce qu'elle comprend donc trois couches 10, 11, 14 au lieu de quatre couches 10, 11, 12, 13, comme dans la première variante. Dans cette deuxième variante, l'accumulateur d'énergie électrique 6 du dispositif d'éclairage autonome 3 est maintenant compris dans la troisième et dernière couche 14 de cet assemblage 9b avec l'unité de contrôle 7.

Une telle troisième et dernière couche 14 de cet assemblage 9b, formant la face cachée du cadran 2b, est constituée d'un substrat de préférence flexible ou souple, sur lequel sont édifiés, de préférence sur la surface supérieure de ce substrat, l'accumulateur 6 et le circuit électronique 8 constituant l'unité de contrôle 7. Une telle édification de l'accumulateur 6 et de l'unité de contrôle 7 sur cette surface supérieure du substrat, peut être réalisée à partir de procédés d'impression tridimensionnelle ou encore des procédés d'impression sur polymère. On notera qu'un tel substrat peut être par exemple un PCB flexible.

En résumé dans cette deuxième variante, l'assemblage 9b comprend alors :
- une première couche 10 formant la face visible 20a du cadran 2b incluant ladite au moins une source lumineuse 4 du dispositif d'éclairage 3 ;
- une deuxième couche 11 incluant le module photovoltaïque 5, et
- la troisième couche 14 formant la face cachée 20b du cadran 2b incluant l'accumulateur 6 et l'unité de contrôle 7.

On notera que dans cette deuxième variante, les première et deuxième couches 10, 11 sont similaires à celles de la première variante de l'assemblage 9a.

Par ailleurs, en référence aux figures 3 et 5, le circuit électronique 8 de l'unité de contrôle 7 comprend des premiers éléments de connexion 15a qui sont reliés à des éléments de connexion 16 de ladite au moins une source lumineuse 4 pour la gestion du fonctionnement de cette source lumineuse 4. Ce circuit électronique 8 comprend aussi des deuxièmes éléments de connexion 15b reliés à des premiers éléments de connexion 17a de l'accumulateur 6.

En outre, on notera que les capteurs d'évènements du dispositif d'éclairage 3, évoqués précédemment sont de préférence agencés dans la première couche 10 et/ou la dernière couche 13, 14 de l'assemblage 9a, 9b en étant reliés à l'unité de contrôle 7 de ce dispositif 3.

Dans une troisième variante non représentée, l'assemblage formant le cadran comprend deux couches reliées entre elles. On remarquera que cette troisième variante se différencie de la deuxième variante en ce qu'elle comprend donc deux couches au lieu de trois couches 10, 11, 14, comme dans cette deuxième variante. Dans cette troisième variante, le module photovoltaïque 5 du dispositif d'éclairage autonome 3 est maintenant compris dans la première couche et en particulier sur la surface inférieure du substrat formant cette première couche. Ce module photovoltaïque 5 peut être appliqué sur cette surface inférieure du substrat de cette première couche à partir de procédés d'impression par jet d'encre ou encore par sérigraphie ou à partir de procédés d'impression par évaporation thermique. On notera donc que cette première couche est alors similaire aux premières couches 11 des première et deuxième variantes, à l'exception du fait que dans cette troisième variante, la première couche comprend en plus le module photovoltaïque.

Par ailleurs dans la troisième variante, et de manière similaire à la deuxième variante, l'accumulateur d'énergie électrique 6 du dispositif d'éclairage autonome 3 est compris dans la deuxième et dernière couche de cet assemblage avec l'unité de contrôle 7. Une telle deuxième couche formant la face cachée du cadran, est constituée d'un substrat de préférence flexible ou souple, sur lequel sont édifiés, de préférence sur la surface supérieure de ce substrat, l'accumulateur 6 et le circuit électronique 8 constituant l'unité de contrôle 7. Cette édification de l'accumulateur 6 et de l'unité de contrôle 7 sur la surface supérieure du substrat, peut être réalisée à partir de procédés d'impression tridimensionnelle ou encore des procédés d'impression sur polymère. On notera qu'un tel substrat peut être par exemple un PCB flexible.

En résumé dans cette troisième variante, l'assemblage comprend alors :
- une première couche formant la face visible 20a du cadran incluant ladite au moins une source lumineuse 4 et le module photovoltaïque 5 du dispositif d'éclairage 3, et
- une deuxième couche formant la face cachée 20b du cadran incluant l'accumulateur 6 et l'unité de contrôle 7.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées.

## Revendications

1. Cadran (2a, 2b) de montre (1) comprenant un dispositif d'éclairage autonome (3) comportant les éléments fonctionnels suivants :
- au moins une source lumineuse (4),
- une unité d'alimentation électrique autonome (21), et
- une unité de contrôle (7) pour gérer le fonctionnement de la dite au moins une source lumineuse (4),
ledit cadran (2a, 2b) étant formé par un assemblage (9a, 9b) d'une pluralité de couches superposées (10, 11, 12, 13, 14) reliées entre elles et comportant chacune un ou plusieurs éléments fonctionnels du dispositif d'éclairage autonome (3).

2. Cadran (2a, 2b) selon la revendication précédente, **caractérisé en ce que** l'assemblage (9a, 9b) est constitué d'une première couche (10) formant une face visible (20a) du cadran (2a, 2b) comprenant au moins une source lumineuse (4).

3. Cadran (2a, 2b) l'une quelconque des revendications précédentes, **caractérisé en ce que** ladite première couche (10) est configurée pour être traversé en tout ou partie par un rayonnement lumineux notamment par un rayonnement solaire.

4. Cadran (2a, 2b) l'une quelconque des revendications précédentes, **caractérisé en ce que** ladite première couche (10) est en tout ou partie transparente ou translucide.

5. Cadran (2a, 2b) selon l'une quelconque des revendications précédentes, **caractérisé en ce que** l'assemblage (9a, 9b) comporte une deuxième couche (11) comprenant un module photovoltaïque (5) constituant l'unité d'alimentation électrique autonome (21).

6. Cadran (2a, 2b) selon l'une quelconque des revendications précédentes, **caractérisé en ce que** la deuxième couche (11) comprend un substrat sur lequel le module photovoltaïque (5) est imprimé.

7. Cadran (2a, 2b) selon l'une quelconque des revendications 5 et 6, **caractérisé en ce que** ledit module photovoltaïque (5) est disposé sur une zone active de ladite deuxième couche (11), ladite zone étant configurée pour recevoir des rayonnements lumineux provenant de la première couche (10) de l'assemblage (9a, 9b).

8. Cadran (2a) selon l'une quelconque des revendications précédentes, **caractérisé en ce que** l'assemblage (9a) comporte une troisième couche (12) comprenant un accumulateur d'énergie électrique (6) constituant l'unité d'alimentation électrique (21) autonome.

9. Cadran (2a) selon la revendication précédente, **caractérisé en ce que** la troisième couche (12) comprend un substrat sur lequel l'accumulateur d'énergie électrique (6) est imprimé.

10. Cadran (2a) selon l'une quelconque des revendications précédentes, **caractérisé en ce que** l'assemblage (9a) comporte une quatrième couche (13) formant une face cachée (20b) du cadran (2a) comprenant l'unité de contrôle (7).

11. Cadran (2b) selon l'une quelconque des revendications 1 à 7, **caractérisé en ce que** l'assemblage (9b) comporte une troisième couche (14) comprenant une face cachée (20b) du cadran (2a) comportant l'unité de contrôle (7) et un accumulateur d'énergie électrique (6) constituant l'unité d'alimentation électrique (21) autonome.

12. Cadran (2a, 2b) selon l'une quelconque des revendications précédentes, **caractérisé en ce que** la première couche (10) est rigide relativement aux autres couches (11, 12, 13, 14) comprises dans l'assemblage (9a, 9b) qui sont souples.

13. Montre (1) comprenant un cadran (2a, 2b) selon l'une quelconque des revendications précédentes.

14. Montre (1) selon la revendication précédente, **caractérisée en ce qu'**elle comprend un mouvement horloger mécanique ou électromécanique ou électronique.
